Europäisches Patentamt

European Patent Office

Office européen des brevets

(11) Veröffentlichungsnummer: **0 273 194**
**A1**

## (12) EUROPÄISCHE PATENTANMELDUNG

(21) Anmeldenummer: 87117269.8

(22) Anmeldetag: 24.11.87

(51) Int. Cl.⁴: **F16B 7/10** , G01R 31/28

(30) Priorität: 23.12.86 DE 3644154

(43) Veröffentlichungstag der Anmeldung:
06.07.88 Patentblatt 88/27

(84) Benannte Vertragsstaaten:
**BE CH DE FR GB IT LI NL**

(71) Anmelder: **Boctor, Grant, Dr.**
**Edelbergstrasse 56**
**D-7500 Karlsruhe 21(DE)**

(72) Erfinder: **Boctor, Grant, Dr.**
**Edelbergstrasse 56**
**D-7500 Karlsruhe 21(DE)**

(74) Vertreter: **Brommer, Hans Joachim, Dr.-Ing. et**
**al**
**Patentanwälte Dipl.-Ing. R. Lemcke Dr.-Ing.**
**H.J. Brommer Amalienstrasse 28 Postfach**
**4026**
**D-7500 Karlsruhe 1(DE)**

(54) **Adapter zur Prüfung von Leiterplatten.**

(57) Die Erfindung betrifft einen mehrstufigen Adapter zur elektrischen Prüfung von Leiterplatten in unterschiedlichen Höhenpositionen relativ zu einer Basisplatte mit Prüfkontakten. Dieser Adapter besteht aus einem Außenteil (22) und einem darin verschiebbaren Innenteil (23), wobei letzteres über ein zwischengeschaltetes, verdrehbares Zwischenelement in zwei unterschiedlichen Höhenpositionen arretierbar ist, die sich automatisch abwechselnd einstellen, wenn Innen (23)- und Außenteil (22) gegeneinander verschoben werden.

Fig. 3

## Adapter zur Prüfung von Leiterplatten

Die Erfindung betrifft einen mehrstufigen Adapter zur elektrischen Prüfung von Leiterplatten, bestehend aus einer an ihrer Oberseite zur Aufnahme der zu prüfenden Leiterplatte (n) geeigneten Trägerplatte und einer an der Unterseite angeordneten Basisplatte, die eine Vielzahl von nadelähnlich hochstehenden, die Trägerplatte durchquerende Prüfkontakte aufweist, wobei die Träger- und die Basisplatte in Richtung der Prüfkontakte relativ zueinander verfahrbar und zur Kontakbtildung der Leiterplatte mit verschieden hohen Prüfkontakten in unterschiedlich hohen Prüfstellungen mittels verstellbarer Anschläge arretierbar sind und wobei zumindest die oberen Prüfkontakte verfahrbar sind.

Bei der Prüfung von Leiterplatten ist es üblich, die aufgelöteten Bauelemente wie Halbleiter, Wiederstände usw. und die dazugehörigen Lötverbindungen durchzumessen. Dazu ist die Basisplatte mit einer Vielzahl nadelähnlicher Prüfkontakte versehen -pro Platte werden mehrere Hundert solcher Prüfkontakte benötigt -, die so positioniert sind, daß sie beim Anlegen der zu prüfenden Leiterplatte mit der gewünschten Lötstelle oder dem gewünschten Leiter in Berührung kommen.

Wesentlich ist nun, daß die Leiterplatte wahlweise entweder mit allen oder nur mit einem Teil der Prüfkontakte in Berührung gebracht werden soll. Dazu stehen die Prüfkontakte unterschiedlich hoch und die Trägerplatte mit der zu prüfenden Leiterplatte ist entsprechenden diesen Höhenpositionen in unterschiedlichen Prüfstellungen arretierbar.

Bei dem eingangs beschriebenen Adapter ist der verstellbare Anschlag zur Herbeiführung unterschiedlicher Prüfpositionen mit Hilfe eines kleinen Getriebemotors herbeigeführt. Dieser Getriebemotor ist unterhalb der Basisplatte angebaut, ragt mit seinem Rotor durch die Basisplatte hindurch und verdreht einen zwischen Basis-und Trägerplatte befindlichen Schwenkarm. In der Trägerplatte ist eine die Form dieses Schwenkarmes aufweisende Aussparung vorgesehen, die in der einen Stellung des Schwenkarmes mit ihm fluchtet, während der Schwenkarm in seiner anderen Stellung an der Unterseite der Trägerplatte anstößt, wenn sie zur Basisplatte verschoben wird. Je nach Stellung des Schwenkarmes wird die Trägerplatte mit der zu prüfenden Leiterplatte also in einer höheren oder in einer tieferen Position arretiert und dementsprechend werden die Prüfkontakte nur teilweise oder vollzählig wirksam.

Diese Art der Anschlagbildung ist jedoch sehr aufwendig. Die Getriebemotoren sind relativ teuer.

Vor allem haben sie nur eine kurze Lebensdauer, weil sie nicht für die Anschlagfunktion und die damit einhergehende Axialbelastung ausgelegt sind.

Eine andere bekannte Lösung besteht darin, den pneumatischen Antrieb, mit dem die Trägerplatte im allgemeinen in Richtung auf die Basisplatte verfahren wird, für das Erreichen verschiedener Höhenpositionen heranzuziehen. Dabei ist es aber schwierig, die gewünschte Position genau einzuhalten, erstens, weil die Rückstellkräfte zum Zurückführen der Trägerplatte in ihre Ausgangsposition nicht konstant sind, zweitens, weil die in gleicher Richtung wirkenden Federkräfte der Prüfkontakte von der Anzahl der betroffenen Prüfkontakte abhängen und drittens, weil die genaue Einhaltung des Unterdruckes schwierig ist.

Von diesem Stand der Technik ausgehend liegt der vorliegenden Erfindung die Aufgabe zugrunde, den eingangs beschriebenen bekannten Adapter dahingehend zu verbessern, daß die Arretierung der Trägerplatte in unterschiedlichen Höhenpositionen bei exakter Einhaltung der gewünschten Höhenposition einfacher und kostengünstiger als bisher realisiert werden kann.

Diese Aufgabe wird erfindungsgemäß dadurch gelöst, daß die verstellbaren Anschläge jeweils aus einem Außenteil, einem darin verschiebbaren Innenteil und einem zwischen Außen-und Innenteil verdrehbar gelagerten, ringförmigen Zwischenelement bestehen, wobei das Außenteil gegenüber dem Innenteil durch eine Feder in der einen Endposition verspann ist, daß das Außenteil über das Zwischenelement mit dem Innenteil in Wirkverbindung steht, derart, daß eine Verschiebung zwischen beiden Teilen eine definierte Verdrehung des Zwischenelementes bewirkt und dabei Anschläge in verschiedenen Höhenpositionen entsprechend den gewünschten Prüfpositionen bei einer Verschiebung entgegen der Federspannung wirksam werden.

Der Erfindung liegt die Erkenntnis zugrunde, daß man den in verschiedenen Höhenpositionen wirksamen Anschlag durch Anwendung des bei Druckknöpfen von Kugelschreibern bekannten Prinzips gewinnen kann. Wie man weiß, wird dabei die Mine des Kugelschreibers abwechselnd in der Schreibposition oder in einer zurückgefahrenen Position arretiert. Die Steuerung der Position erfolgt über das ringförmige Zwischenelement, das bei jeder Betätigung des Druckknopfes ein Stück weitergedreht wird, da es mit diesem über Schrägflächen in Verbindung steht, und das in Abhängigkeit von seiner Drehstellung an Vorsprüngen des Gehäuses anliegt oder passieren kann.

Für die konstruktive Ausgestaltung der beschriebenen Wirkverbindung sind verschiedene Möglichkeiten bekannt. So kann die Wirkverbindung zwischen Außen-und Innenteil über das ringförmige Zwischenelement über stirnseitige Schrägflächen des Zwischenelementes herbeigeführt werden, die abwechselnd mit entsprechenden Schrägflächen des Innen-und des Außenteiles in Anlage kommen und somit bei jeder Hubbewegung die Weiterdrehung des Zwischenelementes bewirken. Auch liegt es im Rahmen der Erfindung, die Verdrehung des Zwischenelementes ausschließlich durch die Verschiebung des Außenteiles oder ausschließlich durch die Verschiebung des Innenteiles herbeizuführen. Auch kann das zwischen Außen-und Innenteil geschaltete Zwischenelement entweder radial des Innen teils oder in dessen axialer Verlängerung angeordnet sein.

Eine besonders robuste Bauform ergibt sich, wenn das ringförmige Zwischenelement als Hülse ausgebildet ist, die zwei aufeinander zugewandte, in Umfangsrichtung laufende Kulissenbahnen aufweist und daß im Zwischenraum zwischen diesen Kulissenbahnen das Innen-oder Außenteil mit dem gewünschten Verschiebespielraum gefangen ist und die eine Kulissenbahn entsprechend den unterschiedlich hohen Prüfpositionen höhenversetzte Tiefpunkte aufweist, an die sich in beiden Umfangsrichtungen ansteigende Kurvenflanken anschließen, wogegen die andere Kulissenbahn jeweils oberhalb dieser Tiefpunkte - schrägverlaufende Kurvenflanken gleicher Steigungsrichtung aufweist, die ihrerseits unter Bildung von Tiefpunkten aufeinanderfolgen. Dadurch ist sichergestellt, daß jede Hubbewegung zwischen Innen-und Außenteil zur Verdrehung der Hülse führt, wobei die erstgenannte Kulissenbahn für das Innen-oder Außenteil, je nach dem welches von beidem mit ihm in Eingriff steht, entsprechend den höhenversetzten Tiefpunkten unterschiedlich hohe Anschlagpositionen definiert.

Eine konkrete Ausgestaltung ist dadurch definiert, daß das Innenteil über radiale Vorsprünge in den Zwischenraum zwischen den beiden Kulissenbahnen ein greift, wobei das Innenteil ein Bolzen, das Außenteil ein zylinderartiges Gehäuse ist.

In diesem Fall hat das Außenteil nur für eine axiale Lagebegrenzung der Hülse zu sorgen, damit die Axialverschiebung des Innenteils die erwünschte Verdrehung der Hülse ergibt. Die Erzeugung der Drehbewegung erfolgt im einfachsten Fall über einen Querstift, der beidseits des Bolzens vorsteht und in den Zwischenraum zwischen den beiden Kulissenbahnen eingreift.

Zweckmäßig steht der Bolzen einseitig aus dem zylindrischen Gehäuse vor, so daß er unmittelbar als Anschlagpuffer fungiert.

Das zylindrische Gehäuse ist dann am günstigsten an der Basisplatte montiert.

Für die Erzeugung der Verschiebbewegung zwischen Trägerplatte und Basisplatte bestehen zahlreiche Möglichkeiten. Aus Kostengründen empfiehlt es sich, den bisher üblichen Vakuumantrieb beizubehalten, so daß auch bereits bestehende Adapter nachträglich leicht umgerüstet werden können.

In diesem Fall ist die Basisplatte als Zylinder, die Trägerplatte als Kolben ausgebildet, wobei der Zwischenraum zwischen beiden Teilen an eine Vakuumquelle angeschlossen ist.

Weitere Merkmale und Vorteile der Erfindung ergeben sich aus der nachfolgenden Beschreibung eines Ausführungsbeispieles anhand der Zeichnung; dabei zeigt

Fig. 1 ein Querschnitt durch einen herkömmlichen Adapter mit elektrischem Anschlag

Fig. 2 einen Querschnitt durch den gleichen Adapter mit dem erfindungsgemäßen Anschlag

Fig. 3 den Anschlag gemäß Fig. 2 in vergrößerter Darstellung im Axialschnitt und

Fig. 4 eine Abwicklung der Schalthülse

Eine Basisplatte 1 ist allseits von Seitenwänden 2 umgeben, so daß ein Aufnahmebehälter für eine Trägerplatte 3 entsteht, die längs einer Randdichtung 4 einigermaßen luftdicht, jedoch vertikal verschiebbar in dem Aufnahmebehälter 1, 2 verschiebbar ist.

Die zu überprüfende Leiterplatte 5 wird in einen Dichtungsrahmen 6 der Trägerplatte 3 eingelegt, wodurch sie eine definierte Position einhält. Ihre zu überprüfenden Bauelemente, von denen hier nur beispielshalber zwei Elemente 7 und 8 dargestellt sind, befinden sich hinsichtlich ihrer Lötstellen oberhalb von Durchgangsbohrungen 9 bis 12 der Trägerplatte 3. In diese Durchgangsbohrungen ragen Prüfkontakte in Form von gefederten Nadeln 9 bis 12 hinein. Sie sind in Kontaktgehäusen 13 bis 16 gegen Federkraft vertikal verschiebbar gelagert. Die Kontaktgehäuse sind ihrerseits in der Basisplatte 1 montiert, und zwar derart, daß ein Teil der Nadeln eine höhere Position aufweist als ein anderer Teil der Nadeln.

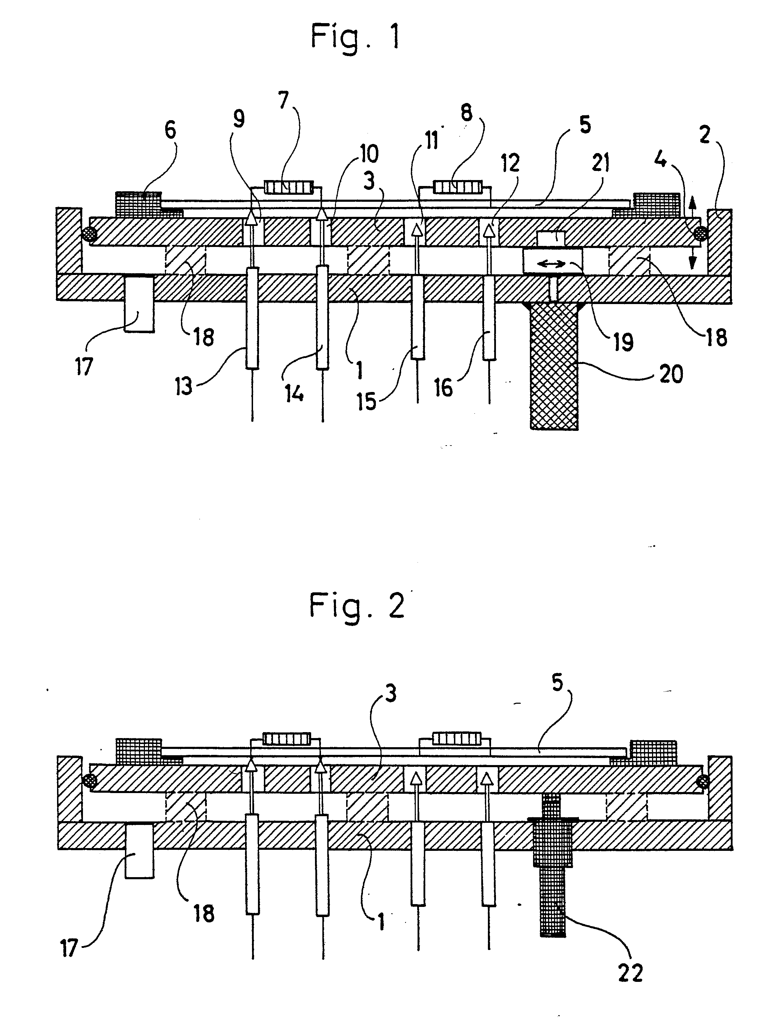

Der Zwischenraum zwischen der Basisplatte 1 und der Trägerplatte 3 ist über einen Anschluß 17 mit einer Vakuumquelle verbunden. Dadurch kann die Trägerplatte 3 entgegen den Federelementen 18 nach unten gezogen werden. Fig. 2 zeigt den Zustand, bei dem die Trägerplatte 3 halb eingetaucht ist, so daß sie Kontakt mit den Nadeln 13 und 14 hat und folglich das Bauelement 7 überprüft werden kann.

Ein verstellbarer Anschlag 19 dient zur exakten Positionierung der Trägerplatte 3 in dieser Zwischenlage. Er ist im bekannten Fall an einen Getriebemotor 20 angeschlossen. Dadurch kann er um 90° verdreht werden, so daß er in eine Aussparung 21 der Trägerplatte hineinpaßt und somit ein weiteres Absenken dieser Trägerplatte zur Kontakbildung mit weiteren Nadeln 15 und 16 ermöglicht.

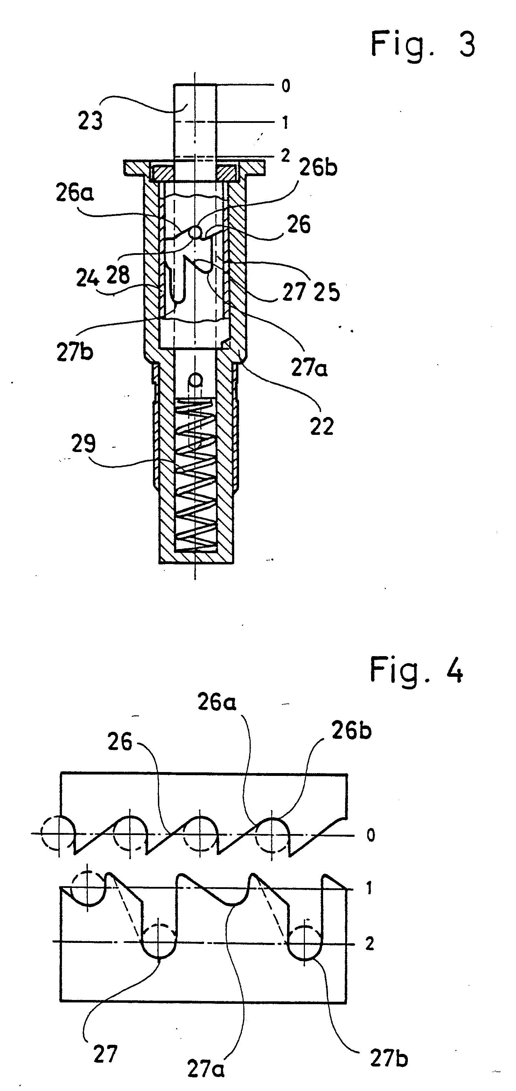

In Fig. 2 ist dieses kostspielige Anschlagsystem durch den erfindungsgemäßen Anschlag ersetzt. Er besteht aus einem Gehäuse 22, das in der Basisplatte 1 montiert ist und einen nach oben vorstehenden, gefederten Bolzen 23 enthält. In der Zeichnung ist dieser Bolzen in der Zwischenposition dargestellt. Wird er durch Abschalten des Unterdruckes am Anschluß 17 und durch das Hochgehen der Trägerplatte 3 freigegeben, so fährt er in seine obere Extremlage aus. Die ist in Fig. 3 dargestellt. Wird er anschließend durch Herunterfahren der Trägerplatte 3 wieder in das Gehäuse 22 hineingedrückt, so passiert er die in Fig. 2 dargestellte Zwischenposition und stößt erst in seiner unteren Endlage an. Wird er danach wieder freigegeben, so führt die darauf folgende Belastung wieder zum Erreichen der in Fig. 2 dargestellten Zwischenposition.

Die Wirkungsweise wird anhand von Fig. 3 näher erläutert.

Wie die Schnittzeichnung zeigt, befindet sich zwischen dem Gehäuse 22 und dem Bolzen 23 eine koaxial angeordnete Schalthülse 24. Sie ist in dem Gehäuse 22 verdrehbar, aber axial unverschiebbar geführt. In ihrem mittleren Bereich weist sie einen in Umfangsrichtung durchlaufenden Zwischenraum 25 auf, der von einer oberen Kulissenbahn 26 und einer unteren Kulissenbahn 27 begrenzt wird. In den Zwischenraum zwischen beiden Kulissenbahnen ragen die beiden überstehenden Enden es den Bolzen 23 durchquerenden Stiftes 28 hinein. Dieser Stift 28 korrespondiert mit den beiden Kulissenbahnen und bewirkt bei Betätigung des Bolzens 23 die Verdrehung der Schalthülse 24. Zu diesem Zweck weist die obere Kulissenbahn, gegen die der Stift 28· durch die Druckfeder 29 gedrückt wird, eine sägezahnartige Kontur auf mit der Maßgabe, daß vier im gleichen Steigungssinn ansteigende Kurvenäste 26a vorhanden sind, die unter Bildung jeweils eines Tiefpunktes 26b und durch jeweils einen sich daran anschließenden vertikalen Kurvenast jeweils miteinander verbunden sind. Die Abwicklung dieses Kurvenzuges ist in Fig. 4 dargestellt.

Die untere Kulissenbahn 27 ist für die Anschlagbildung beim Hineindrücken des Bolzens 23 in zwei unterschiedlichen Höhenpositionen verantwortlich. Sie weist hierzu zwei sich radial gegenüberliegende obere Tiefpunkte 27a und zwei um 90° versetzte, sich ebenfalls radial gegenüberliegende, untere Tiefpunkte 27b auf. Wesentlich ist nun, daß die Tiefpunkte 27a und 27b jeweils vertikal unter den schräg ansteigenden Kurvenästen der oberen Kulissenbahn 26 liegen, wie dies aus Fig. 4 deutlich erkennbar wird.

Geht man von der in Fig. 3 dargestellten Position aus, so entspricht die Höhe des Bolzens 23 der oberen Ruhelage der Trägerplatte 3, das heißt, daß die zu prüfende Leiterplatte noch keine Berührung mit den Nadeln 13 bis 16 hat. Wird nun durch Unterdruck die Trägerplatte 3 und damit auch der Bolzen 23 nach unten gedrückt, so stößt der Stift 28 nach einiger Zeit gegen die Flanke der unteren Kulissenbahn 27. Diese Flanke verläuft mit entgegengesetzter Steigung wie die schrägen Kurvenäste der oberen Kulissenbahn, so daß der Stift 28 die Schalthülse 24 nach links verdreht, bis der Tiefpunkt 27a erreicht ist. Dies ist die Anschlagposition für die Zwischenhöhe der Leiterplatte 5.

Nach Beendigung der in dieser Plattenposition durchzuführenden Prüfungen wird der Unterdruck kurzzeitig aufgehoben, so daß die Federn 18 und 29 den Plattenträger 3 bzw. den Bolzen 23 nach oben schieben. Dabei stößt der Stift 28 an den -schrägverlaufenden Kurvenast der oberen Kulissenbahn 26 und verdreht die Hülse 24 weiter nach links, bis der Stift 28 den nächsten Tiefpunkt 26b der oberen Kulissenbahn erreicht hat. Bei dem darauffolgenden nach unten fahren trifft der Stift 28 auf eine zum unteren Tiefpunkt 27b laufende Schrägfläche der unteren Kulissenbahn. Die ist die untere Anschlagposition.

Nach dem Meßvorgang in der unteren Position wird die Trägerplatte 3 wieder freigegeben, worauf der Bolzen 23 in die gezeichnete obere Position zurückkehrt und sich der Vorgang bei der Prüfung der nächsten Leiterplatte 5 wiederholt.

Im Ausführungsbeispiel sind die jeweiligen Tiefpunkte einer Kulissenbahn jeweils um 90° in Umfangsrichtung versetzt, so daß unter Berücksichtigung des paarweisen Eingriffes zwei verschieden hohe Anschlagpositionen zur Verfügung stehen. Es liegt aber auch im Rahmen der Erfindung, die Tiefpunkte enger zu legen, beispielsweise nur um 60° zu versetzen, so daß man drei verschieden hohe Anschlagpositionen erhält.

Selbstverständlich liegt auch eine kinematische Umkehr der beschriebenen Bewegungsverhältnisse unter entsprechender Anpassung der jeweiligen Teile im Rahmen der Erfindung.

Schließlich liegt es im Rahmen der Erfindung, die Schalthülse aus mehreren Teilen zusammenzubauen, etwa aus einem die obere Kulissenbahn 26 tragenden Hülsenteil, einem die untere Kulissenbahn 27 tragendem Hülsenteil und einem beiden Teile miteinander drehfest verbindenden Zylinder.

## Ansprüche

1. Mehrstufiger Adapter zur elektrischen Prüfung von Leiterplatten bestehend aus einer an ihrer Oberseite zur Aufnahme der zu prüfenden Leiterplatte (n) geeigneten Trägerplatte und einer an der Unterseite angeordneten Basisplatte, die eine Vielzahl von nadelähnlich hochstehenden, die Trägerplatte durchquerenden Prüfkontakte aufweist, wobei die Träger-und die Basisplatte in Richtung der Prüfkontakte relativ zueinander verfahrbar und zur Kontaktbildung der Leiterplatte mit verschieden hohen Prüfkontakten in unterschiedlich hohen Prüfstellungen mittels verstellbarer Anschläge arretierbar sind und wobei zumindest die oberen Prüfkontakte verfahrbar sind,
dadurch gekennzeichnet,
daß die verstellbaren Anschläge jeweils aus einem Außenteil (22), einem darin verschiebbaren Innenteil (23) und einem zwischen Außen-und Innenteil geschalteten, verdrehbar gelagerten, ringförmigen Zwischenelement (24) bestehen, wobei das Innenteil (23) gegenüber dem Außenteil (22) durch eine Feder (29) in der einen Endposition verspannt ist, daß das Innenteil (23) über das Zwischenelement (24) mit dem Außenteil (22) in Wirkverbindung steht, derart, daß eine Verschiebung zwischen beiden Teilen (22, 23) eine definierte Verdrehung des Zwischenelementes (24) bewirkt und dabei Anschläge (27a, 27b) in verschiedenen Höhenpositionen entsprechend den gewünschten Prüfpositionen bei einer Verschiebung entgegen der Federspannung wirksam werden.

2. Adapter nach Anspruch 1, dadurch gekennzeichnet, daß das ringförmige Zwischenelement (24) als Hülse ausgebildet ist, die zwei aufeinander zugewandte, in Umfangsrichtung umlaufende Kulissenbahnen (26, 27) aufweist, daß zwischen diesen Kulissenbahnen (26,27) das Innen-oder Außenteil mit dem gewünschten Verschiebespielraum gefangen ist und die eine Kulissenbahn (27) entsprechend den gewünschten Prüfpositionen höhenversetzte Tiefpunkte (27a, 27b) aufweist, an die sich in beiden Umfangsrichtungen ansteigende Kurvenflanken anschließen, wogegen die andere Kulissenbahn (26) jeweils oberhalb dieser Tiefpunkte (27a, 27b) schräg verlaufende Kurvenflanken (26a) gleicher Steigungsrichtung aufweist, die ihrerseits unter Bildung von Tiefpunkten (26b) aufeinanderfolgen.

3. Adapter nach Anspruch 2, dadurch gekennzeichnet, daß das Innenteil (23) über radiale Vorsprünge (28) in den Zwischenraum (25) zwischen den beiden Kulissenbahnen (26, 27) eingreift.

4. Adapter nach einem der vorhergehenden Ansprüche, dadurch gekennzeichnet, daß das Innenteil (23) ein Bolzen ist.

5. Adapter nach einem der vorhergehenden Ansprüche, dadurch gekennzeichnet, daß das Außenteil (22) ein zylinderartiges Gehäuse ist.

6. Adapter nach Anspruch 3 und 4, dadurch gekennzeichnet, daß der Bolzen (23) über einen beidseits vorstehenden Querstift (28) in den Zwischenraum (25) zwischen den beiden Kulissenbahnen (26, 27) eingreift.

7. Adapter nach einem der vorhergehenden Ansprüche, dadurch gekennzeichnet, daß das Innenteil (23) einseitig aus dem Außenteil (22) vorsteht.

8. Adapter nach Anspruch 5, dadurch gekennzeichnet, daß das zylindrische Gehäuse (22) in der Basisplatte (1) montiert ist.

9. Adapter nach einem der vorhergehenden Ansprüche, dadurch gekennzeichnet, daß die Verschiebebewegung zwischen Basisplatte 1 und Trägerplatte 3 pneumatisch erfolgt.

10. Adapter nach Anspruch 9, dadurch gekennzeichnet, daß die Trägerplatte 3 annähernd luftdicht, jedoch verschiebbar in der zylinderartig ausgebildeten Basisplatte 1 geführt ist und die Verschiebebewegung durch Unterdruck erfolgt.

# Fig. 1

# Fig. 2

Fig. 3

23
0
1
2  26b
26a
26
24 28
27 25
27b
27a
22
29

Fig. 4

26a
26
26b
0
1
2
27
27a
27b

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| Y | DE-A-3 031 137 (SIEMENS AG) * Ansprüche 1, 7, Figur, Positionen 9, 10 * | 1,4,5 | F 16 B 7/10 G 01 R 31/28 |
| A | | 2,3,9, 10 | |
| | --- | | |
| Y | US-A-3 469 870 (H.A. BARKKS) * ganzes Dokument * | 1,4,5 | |
| A | | 2,3 | |
| | ----- | | |

RECHERCHIERTE SACHGEBIETE (Int. Cl.3)

F 16 B 7/10
F 16 B 7/14
G 01 R 31/28

Der vorliegende Recherchenbericht wurde für alle Patentansprüche erstellt

| Recherchenort | Abschlußdatum der Recherche | Prüfer |
|---|---|---|
| BERLIN | 17-03-1988 | LEMMERICH J |